# EUROPEAN PATENT SPECIFICATION

(11) **EP 3 557 711 B1**
(45) Date of publication and mention of the grant of the patent: **15.11.2023**
(21) Application number: 19169189.8
(22) Date of filing: 15.04.2019
(51) Int. Cl.: H02H 5/10, G01R 31/08

(54) **CONTROL AND PROTECTION DEVICE FOR DETECTING THE LOSS OF GROUND REFERENCE IN FACILITIES, MACHINES AND ELECTRICAL EQUIPMENT**
STEUER- UND SCHUTZVORRICHTUNG ZUM ERFASSEN DES VERLUSTES DER BEZUGSMASSE IN ANLAGEN, MASCHINEN UND ELEKTRISCHEN AUSRÜSTUNGEN
DISPOSITIF DE COMMANDE ET DE PROTECTION POUR DÉTECTER LA PERTE DE RÉFÉRENCE DE MISE À LA TERRE DANS DES INSTALLATIONS, DES MACHINES ET UN ÉQUIPEMENT ÉLECTRIQUE

(30) Priority: 18.04.2018 ES 201830551 U
(43) Date of publication of application: 23.10.2019
(73) Proprietor: Mazel Asistencia Industrial, S.L., 46013 Valencia (ES)
(72) Inventor: CASERO GÓMEZ, Jose Luis, 46013 VALENCIA (ES)
(74) Representative: Ungria López, Javier

(56) References cited:
- DE-A1-102016 105 882
- US-A1- 2016 315 461
- US-B1- 7 400 476

## Description

### OBJECT OF THE INVENTION

The present invention refers to the technical field of electrical protection systems and more specifically devices for controlling and protecting to detect the loss of ground reference in facilities, machines and electrical equipment that can be isolated.

### BACKGROUND OF THE INVENTION

Every machine or industrial facility must have protection against indirect contacts. For industrial three-phase networks and TT or TN connection systems, this protection happens due to having a correct grounding between the metal mass of the equipment and the grounding point, which is achieved through the protective conductor of the power supply circuit and additionally through the supplementary equipotential connection conductors or conductive elements.

When, due to a breakdown or a similar situation, the continuity of the protective conductor is lost and furthermore there are no other paths for connecting with the grounding circuit, the equipment turns to an isolated situation and with this the protections provided against indirect contact in TT or TN systems are canceled out. In this situation, an earth-leakage or a phase-mass inversion becomes a very dangerous situation for people, given that the elements provided for the detection thereof are inhibited, and currently in the state of the art there are no devices which control and warn about this situation. Tests have been performed with elements available on the market, but the results have been negative and in some cases, the devices used (i.e. voltage relays) have caused dangerous return voltages.

Logic and experience say that is it more likely that this breakdown occurs in mobile elements such as overhead conveyors, transfer trolleys, etc., which move on wheels manufactured from highly resistant materials and on rails coated in materials with low conductivity, and which further include in the protective circuit thereof friction elements such as electrified rails and contact brushes.

Therefore, there is a need not met by the state of the art for detecting the lack of continuity with the ground protective circuit due to the loss of the protective conductor, as well as doing it in a safe manner, without transmitting dangerous contact voltages, understood as those which cause a contact voltage greater than 24 V in conductive locations or sites and 50 V in other cases.

Known prior art comprises document US2016/315461 A1, where it is disclosed an insulation monitoring device which comprises a voltage monitoring circuit for permanently registering the conductor voltage to ground potential for at least one active conductor. If an excess voltage is detected on an active conductor, the voltage monitoring circuit generates a shut-down signal so as to shut down the power supply system. However, it refers to protective equipment designed for acting during a ground fault, but it is useless to prevent the ground fault as it does not offer protection before the ground fault occurs.

### DESCRIPTION OF THE INVENTION

With the aim of reaching the objectives and preventing the drawbacks mentioned previously, the present invention proposes a device for controlling and protecting which detects the loss of ground reference, in addition to doing so in a safe manner, i.e. without transmitting dangerous voltages to the mass of the equipment when it is isolated from the ground.

The application wherein the greater use thereof is foreseen is in mobile equipment or in fixed equipment wherein the only ground connection point of the equipment is through the protection conductor included in the power circuit.

To that end, it is described, in one aspect of the invention, a device for controlling and protecting against electrical failures in a power supply system of a three-phase network with a protective conductor, comprising:
- first acquisition means of each of the phases of the three-phase network;
- second acquisition means of a signal from the protective conductor;
- control means configured for detecting a voltage value between each of the phases and the protective conductor and determining a loss of ground reference if said voltage value exceeds a pre-established threshold;
- at least one electrical cut-off element switchable between a closed state for conduction and an open state for interrupting power from the second acquisition means, wherein switching from a closed state to an open state occurs as a result of the determination of the loss of ground reference, the aim of which is to isolate the device from the second acquisition means; and
- transmission means configured to transmit an electrical failure signal to external equipment, as a result of the determination of the loss of ground reference.

The transmission means, according to one of the embodiments of the invention, consist of the relays K1, K2, K3 and K4 (8) and the signal terminals (27 and 28) connected to said relays (8). The microcontroller (3) manages the state of these relays (open or closed) depending on whether a failure is detected or not, and on the type of failure. Thus, these terminals transmit the information outside of the equipment, since the electrical cut-off element (K5 and K6) is a safety element for the equipment but it does not activate an external safety nor does it communicate the failure. Therefore, the transmission means are the ones responsible for transmitting this information outside to some external equipment. In this embodiment, relays and terminals are used, but in other embodiments other elements with the same transmission function can be used.

One of the embodiments of the present invention envisages incorporating a protective casing in the device, which houses on the inside thereof all the components of the device.

Additionally, in one of the embodiments of the present invention, a power board is envisaged in the device, with an AC/DC power source arranged between the three-phase network and the control means.

Additionally, in one of the embodiments of the present invention, a motherboard is envisaged which houses the control means and the switchable electrical cut-off element.

Optionally, one of the embodiments of the invention envisages that the first and the second acquisition means are a first and a second input terminals, arranged on the outside of the protective casing and able to be connected to the power board and to the motherboard respectively inside the protective casing.

Optionally, one of the embodiments of the invention envisages that the transmission means are a plurality of relays switchable between an open state and a closed state, connected to a third and a fourth output terminals, arranged on the outside of the casing, wherein the state of said relays is responsive to the signals sent from the control means depending on the detection of the loss of ground reference . Thus, advantageously, an indication can be provided to the user about the type of electrical failure detected simply by establishing a code which relates the combinations of the states of the relays to the electrical failure detected.

The present invention envisages, in one of the embodiments thereof, a first bus arranged between the power board and the motherboard.

The present invention envisages, in one of the embodiments thereof, a second bus arranged between the power board and the motherboard.

The control means comprise, according to one of the embodiments of the invention, a microcontroller.

One of the embodiments of the invention additionally comprises a restart button configured to establish an initial state of the device with the electrical cut-off element in the conductive closed state.

Additionally, the device of the present invention comprises, in one of the particular embodiments thereof, visual indicators of an operating status of the device. Thus, advantageously, the user is provided with an indication of, for example, if the device is turned on/off or if any type of electrical failure has been detected.

The device of the present invention, in one of the particular embodiments thereof, envisages having redundant safety by including in the current cut-off element at least two power relays connected in series and arranged between the second acquisition means and the control module.

Another aspect of the invention refers to a method for controlling and protecting against electrical failure in a power supply system of a three-phase network with a protective conductor CP, comprising the following steps:
- measuring, by a control means, the voltage of each of the three phases R, S and T;
- measuring, by the control means, a voltage value between each of the phases and the protective conductor;
- performing the measurements of the previous steps in an uninterrupted cyclical manner;
- in case the control means detects a voltage exceeding a pre-established threshold during the measurements performed, determining a loss of ground reference; and
- activating a relay in order to emit an electrical failure signal to external equipment, as a result of the determination of the loss of ground reference.

Therefore, the device and method of the present invention has a multitude of technical features which imply advantageous effects not reachable by the solutions existing in the state of the art.

### BRIEF DESCRIPTION OF THE FIGURES

To complete the description of the invention, and for the purpose of helping to make the features thereof more readily understandable, according to a preferred exemplary embodiment thereof, a set of figures is included where, by way of illustration and not limitation, the following has been represented:
- **Figure 1** represents a block diagram of one of the embodiments of the present invention.
- **Figure 2** represents a front view of an embodiment of the present invention.
- **Figure 3** represents a detail view of elements and connections of one of the embodiments of the invention.

### DESCRIPTION OF A PREFERRED EMBODIMENT OF THE INVENTION

The present invention discloses a device for controlling and protecting against electrical failures in three-phase electrical power supply systems to industrial machines and facilities.

The device for controlling and protecting of the present invention detects different electrical failures that can occur in the three-phase electrical power supply to industrial machines and facilities. It is based on measuring the characteristic voltages between the active conductors R, S and T and the protective conductor CP. Thus, unlike the devices existing in the state of the art, it allows detecting failures which are related to the protective conductor CP, and furthermore make it in a safe manner, whether it is a loss of reference from breakage or a crossing with an active conductor, which may cause a significant problem in terms of safety in certain industrial applications.

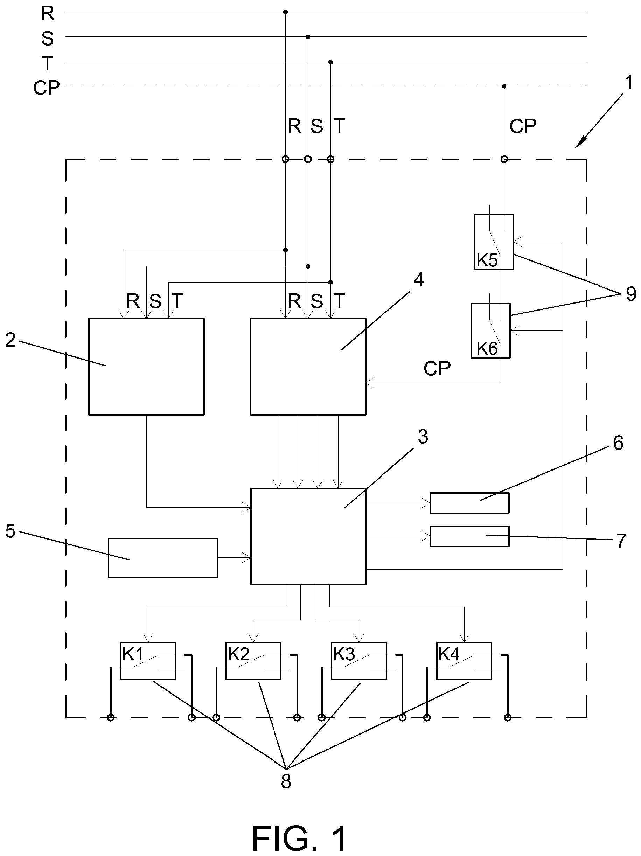

The device for controlling and protecting of the present invention, according to the embodiment shown in **Figure 1****,** connects to the three-phase power supply , such that it directly acquires the signals R, S, T and CP.

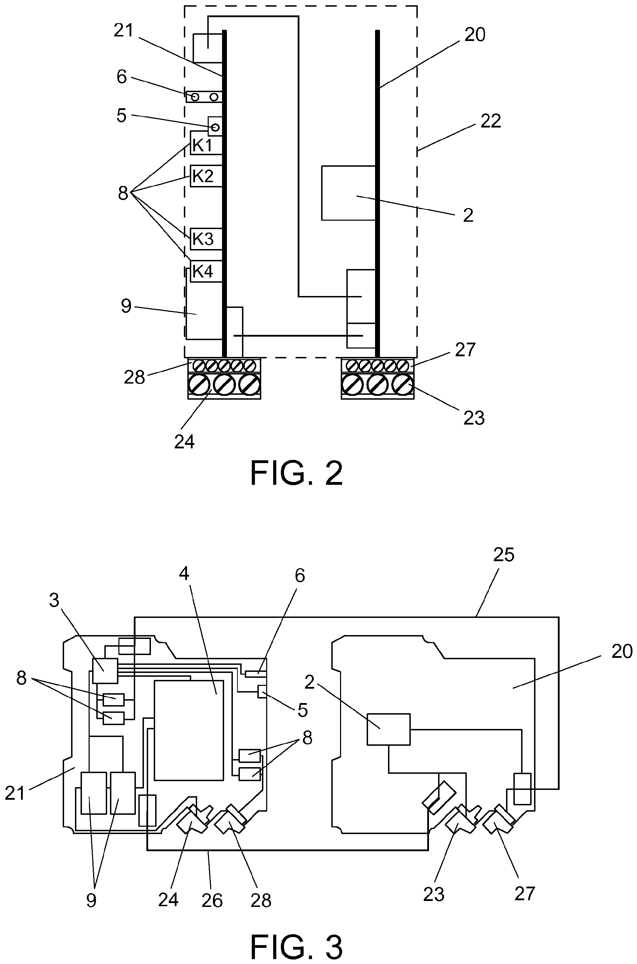

The device for controlling and protecting against electrical failures of the present invention, in a preferred embodiment, is made up of two printed circuit boards which house the electrical and electronic components making up the device. In **Figures 2 and 3** these two boards can be seen, specifically a PSU board **(20)** (power supply unit) and a CPU board **(21)** (central processing unit). Both boards are mounted inside a plastic housing **(22)** specifically configured to be coupled to the boards and enable the installation of the assembly in a standard DIN rail of the kind commonly used for the assembly of electrical elements. The casing has input terminals **(23),** which are able to be directly connected to the three-phase network, an input terminal **(24)** able to be connected to the protective conductor, output terminals **(27)** able to be connected to each of the poles of the potential-free contacts of the alarm relays K1 and K2 and output terminals **(28)** able to be connected for each of the poles of the potential-free contacts of the alarm relays K3 and K4. The connection between both boards is made by means of a first bus **(25)** for powering the CPU board from the AC/DC power supply located in the PSU board and for connecting relays K1 and K2 with the terminals thereof, and a second bus **(26)** for providing the signals R, S and T acquired from the three-phase network to the CPU board.

The CPU board incorporates a microcontroller **(3)** (MCU), a circuit **(4)** for capturing data to be processed, alarm relays **(8)** which, in this preferred embodiment are K1, K2, K3 and K4, (although they can vary in number without leaving the scope of the present invention), power relays **(9),** in this embodiment are K5 and K6 (i.e. opting for implementing two relays in a redundant manner in order to increase the safety category with the aim that a failure in any of these two relays does not lead to the loss of the safety function which they carry out; however, in other embodiments they can be substituted by a single relay or a number greater than two), a reset button **(5)** and status LEDs, for example an active "ON" status LED **(6)** and an "alarm" status LED **(7).**

The signals R, S, T and CP acquired directly from the electrical grid by the data acquisition circuit **(4)** are delivered to the microcontroller **(3)** in order to be analyzed and to evaluate the value of the voltage in each of the phases, in the protective conductor CP and the sequence of phases.

The analysis of the signals delivered to the microcontroller consists of determining the characteristic voltage of each of them and comparing it to the fundamental reference values. Depending on the variations in the value of the voltage with respect to the fundamental reference values, the microcontroller [MCU] determines what kind of failure has been produced in the electrical network in the connection point of the device.

Depending on the relative arrangement of the neutral conductor and of the protective conductor, two types of TN systems are distinguished. In this manner, the TN-S systems are differentiated, wherein the neutral conductor and the protective conductor are different in all of the system and the protective conductor is called CP; and the TN-C systems, wherein the neutral and protective functions are combined in a single conductor in all of the system and wherein the protective conductor receives the name CPN. In these systems the masses of the receiving installation are connected to a ground connection joined to the ground connection of the power supply. Moreover, there are the TT systems, which have a power supply point, generally neutral or compensator, connected directly to the ground. In these systems, the masses of the receiving installation are connected to a ground connection separated from the ground connection of the power supply.

Advantageously, the device for controlling and protecting of the present invention is applicable to all the previous scenarios and can detect the following failures: loss/lack of the protective conductor, both in a TN-C system [NCP, PEN, CP, PE] and in a TN-S or TT system [CP, PE]; loss/lack of one of the phases (R, S, T); change in the sequence of phases (crossing between two phases); change/crossing between one phase and the protective conductor or any combination of the previous failures.

As a response to the detection of a failure, the microcontroller emits an alarm signal actuating on the state of the alarm relays. In one preferred embodiment it has four relays K1, K2, K3 and K4 and by way of example, the following table is shown with the correspondence between the possible failures detected and the state of each of the relays:

| **Type of failure** | **State of the relays** | | | |
|---|---|---|---|---|
| | **K1** | **K2** | **K3** | **K4** |
| The device works and there are no defects | closed | closed | closed | open |
| The device does not work | closed | closed | closed | closed |
| 2 phases are lacking | closed | closed | closed | closed |
| CP (ground) is lacking | open | open | closed | open |
| Crossing of 2 phases and CP is lacking | open | open | closed | open |
| Phase R is lacking | open | open | closed | open |
| Phase S is lacking | open | open | closed | open |
| Phase T is lacking | open | open | closed | open |
| R-CP (ground) crossing | open | open | closed | open |
| S-CP (ground) crossing | open | open | closed | open |
| T-CP (ground) crossing | open | open | closed | open |
| Phase and CP (ground) are lacking | open | open | closed | open |
| CP (ground) and phase to CP are lacking | open | open | closed | open |
| R-S crossing | closed | closed | open | open |
| R-T crossing | closed | closed | open | open |
| T-S crossing | closed | closed | open | open |

The device for controlling and protecting of the present invention advantageously prevents a possible transfer of dangerous voltages between the active conductors and the protective conductor CP when there is a loss of ground reference, by means of the implementation of power relays **(9),** which in this preferred embodiment consist of two relays K5 and K6, with contacts connected in series and joined to the terminal of the protective conductor CP, which are opened in the presence of this failure.

The sequence of operations of the device for detecting electrical failures of the present invention, according to a particular embodiment, begins with starting up the device and activating the relays K5 and K6 (with which it changes from an open state, wherein they do not enable the passage of the current, to a closed state wherein they enable the passage of the current) and, once the relays are activated, the sequence comprises the following steps:
1) Measuring the voltage of the protective conductor CP, in order to determine the existence of said CP, by means of the microcontroller.
2) Measuring the phase order, by means of the microcontroller.
3) Measuring the voltage of each of the phases R, S and T, by means of the microcontroller.
4) Performing the measurements of the three previous steps in an uninterrupted, cyclical manner. The device is in test mode.
5) In the case that the microcontroller detects a failure during the measurements performed in the test mode, activating the corresponding relays in order to emit an alarm:
   - Relay K1: CP is lacking, one of the phases R/S/T is lacking or crossing of connection between phase and CP.
   - Relay K2: CP is lacking, one of the phases R/S/T is lacking or crossing of connection between phase and CP.
   - Relay K3: Change in the sequence of phases (wrong order of connection of phases R/S/T).
   - Relay K4: Equipment powered and working.
6) In the case of failure in CP, the relay K5 and the relay K6 go from the Closed State to the Open State.

If the reset button (5) is pushed at any time in the previous sequence, the device restarts and starts again from the beginning, i.e. starting up the device and activating the relays K5 and K6.

In the case that the microcontroller detects a failure, and if the reset button is not pressed, the device is configured to restart automatically by itself once a certain period of time has passed, for example 15 minutes, according to one of the embodiments.

The device has visual notification means, which preferably consist of two light-emitting diodes (LED). Thus, in one of the embodiments two notification LEDs are integrated in the front of the device: an "On" LED (6) indicating that the equipment is in operation by means of a visual indication, for example a blinking green light; and an "Alarm" LED (7) indicating that the equipment is in alarm mode by means of a visual indication, preferably different from the previous one, for example a blinking red light.

The present invention should not be limited by the embodiment herein described. Other arrangements may be carried out by those skilled in the art based on the present description. Accordingly, the scope of the invention is defined by the following claims.

## Claims

1. A device for controlling and protecting (1) against electrical failures in a power supply system of a three-phase network with a protective conductor, wherein the device comprises:
- first acquisition means (23) of each of the phases of the three-phase network;
- second acquisition means (24) of a signal from the protective conductor;
**characterized in that** the device further comprises:
- control means (3, 4) configured for detecting a voltage value between each of the phases and the protective conductor and determining a loss of ground reference if said voltage value exceeds a pre-established threshold;
- at least one electrical cut-off element (9) switchable between a closed state for conduction and an open state for interrupting power from the second acquisition means (24), wherein the switching from a closed state to an open state occurs as a result of the determination of the loss of ground reference; and
- transmission means (8, 27 and 28) configured to transmit an electrical failure signal to external equipment, as a result of the determination of the loss of ground reference.

2. The device according to claim 1, further comprising a protective casing (22) which houses on the inside thereof all the components of the device.

3. The device according to any of the preceding claims, further comprising a power board (20) with an AC/DC power source (2) arranged between the three-phase network and the control means.

4. The device according to any of the preceding claims, further comprising a motherboard (21) which houses the control means and at least one switchable electrical cut-off element.

5. The device according to claims 2-4 , wherein the first and the second acquisition means are a first (23) and a second (24) input terminals, arranged on the outside of the protective casing and able to be connected to the power board and to the motherboard, respectively, inside the protective casing.

6. The device according to the preceding claims, wherein the transmission means comprise a third (27) and a fourth (28) output terminals, arranged on the outside of the casing and able to be connected to the power board and to the motherboard, respectively, inside the casing.

7. The device according to claim 6, wherein the transmission means comprise a plurality of relays (8) switchable between an open state and a closed state connected to the third and fourth output terminals, wherein the state of said relays is responsive to the signals sent from the control means depending on the detection of the loss of ground reference.

8. The device according to claims 3 and 4, further comprising a first bus (25) arranged between the power board and the motherboard.

9. The device according to claim 8, further comprising a second bus (26) arranged between the power board and the motherboard.

10. The device according to any of the preceding claims, wherein the control means comprise a microcontroller (3).

11. The device according to any of the preceding claims, further comprising a restart button (5) configured to establish an initial state of the device.

12. The device according to any of the preceding claims, further comprising visual indicators (6,7) of an operating status of the device.

13. The device according to any of the preceding claims, wherein at least one switchable electrical cut-off element comprises two power relays connected in series and arranged between the second acquisition means and the control means.

14. A method for controlling and protecting against electrical failure in a power supply system of a three-phase network with a protective conductor CP, **characterized by** comprising the following steps:
- measuring, by a control means, the voltage of each of the three phases ( R, S and T);
- measuring, by the control means, a voltage value between each of the phases and the protective conductor;
- performing the measurements of the previous steps in an uninterrupted cyclical manner;
- in case the control means detects a voltage exceeding a pre-established threshold during the measurements performed, determining a loss of ground reference; and
- activating a relay in order to emit an electrical failure signal to external equipment, as a result of the determination of the loss of ground reference.

## Patentansprüche

1. Vorrichtung zur Steuerung und zum Schutz (1) gegen elektrische Störungen in einem Stromversorgungssystem eines Dreiphasennetzes mit einem Schutzleiter, wobei die Vorrichtung umfasst:
- eine erste Erfassungseinrichtung (23) für jede der Phasen des Dreiphasennetzes;
- eine zweite Erfassungseinrichtung (24) eines Signals vom Schutzleiter;
**dadurch gekennzeichnet, dass** die Vorrichtung des Weiteren umfasst:
- eine Steuerungseinrichtung (3, 4), die zum Erfassen eines Spannungswertes zwischen jeder der Phasen und dem Schutzleiter und zum Bestimmen eines Verlustes der Massereferenz konfiguriert ist, wenn der Spannungswert einen vorher festgelegten Schwellenwert übersteigt;
- wenigstens ein elektrisches Abschaltelement (9), das zwischen einem geschlossenen Zustand zum Leiten und einem offenen Zustand zum Unterbrechen der Stromversorgung von der zweiten Erfassungseinrichtung (24) umschaltbar ist, wobei das Umschalten von einem geschlossenen Zustand in einen offenen Zustand als Ergebnis des Bestimmens des Verlustes der Massereferenz erfolgt; und
- eine Übertragungseinrichtung (8, 27 und 28), die konfiguriert sind, um ein Signal einer elektrischen Störung an ein externes Gerät als ein Ergebnis des Bestimmens des Verlustes der Massereferenz zu übertragen.

2. Vorrichtung nach Anspruch 1, die des Weiteren ein Schutzgehäuse (22) umfasst, das in seinem Inneren alle Komponenten der Vorrichtung aufnimmt.

3. Vorrichtung nach einem der vorhergehenden Ansprüche, die des Weiteren eine Leistungsplatine (20) mit einer Wechsel-/Gleichstromquelle (2) umfasst, die zwischen dem Dreiphasennetz und der Steuerungseinrichtung angeordnet ist.

4. Vorrichtung nach einem der vorhergehenden Ansprüche, die des Weiteren eine Hauptplatine (21) umfasst, auf der die Steuerungseinrichtung und wenigstens ein schaltbares elektrisches Abschaltelement untergebracht sind.

5. Vorrichtung nach einem der Ansprüche 2 - 4, wobei die erste und die zweite Erfassungseinrichtung ein erster (23) und ein zweiter (24) Eingangsanschluss sind, die an der Außenseite des Schutzgehäuses angeordnet sind und mit der Leistungsplatine bzw. der Hauptplatine im Inneren des Schutzgehäuses verbunden werden können.

6. Vorrichtung nach einem der vorhergehenden Ansprüche, wobei die Übertragungseinrichtung einen dritten (27) und einen vierten (28) Ausgangsanschluss umfasst, die an der Außenseite des Gehäuses angeordnet sind und mit der Leistungsplatine bzw. der Hauptplatine im Inneren des Gehäuses verbunden werden können.

7. Vorrichtung nach Anspruch 6, wobei die Übertragungseinrichtung eine Vielzahl von Relais (8) umfasst, die zwischen einem offenen Zustand und einem geschlossenen Zustand umschaltbar und mit dem dritten und vierten Ausgangsanschluss verbunden sind, wobei der Zustand der Relais auf die von der Steuerungseinrichtung gesendeten Signale abhängig vom Erfassen des Verlustes der Massereferenz reagiert.

8. Vorrichtung nach den Ansprüchen 3 und 4, die des Weiteren einen ersten Bus (25) umfasst, der zwischen der Leistungsplatine und der Hauptplatine angeordnet ist.

9. Vorrichtung nach Anspruch 8, die des Weiteren einen zweiten Bus (26) umfasst, der zwischen der Leistungsplatine und der Hauptplatine angeordnet ist.

10. Vorrichtung nach einem der vorhergehenden Ansprüche, wobei die Steuerungseinrichtung eine Mikrosteuerung (3) umfasst.

11. Vorrichtung nach einem der vorhergehenden Ansprüche, die des Weiteren eine Neustart-Taste (5) umfasst, die konfiguriert ist, um einen Ausgangszustand der Vorrichtung herzustellen.

12. Vorrichtung nach einem der vorhergehenden Ansprüche, die des Weiteren visuelle Anzeigen (6, 7) für einen Betriebszustand der Vorrichtung umfasst.

13. Vorrichtung nach einem der vorhergehenden Ansprüche, wobei wenigstens ein schaltbares elektrisches Abschaltelement zwei Leistungsrelais umfasst, die in Reihe geschaltet und zwischen der zweiten Erfassungseinrichtung und der Steuerungseinrichtung angeordnet sind.

14. Verfahren zur Steuerung und zum Schutz gegen elektrische Störungen in einem Stromversorgungssystem eines Dreiphasennetzes mit einem Schutzleiter CP, **gekennzeichnet durch** das Umfassen der folgenden Schritte:
- Messen durch eine Steuerungseinrichtung der Spannung von jeder der drei Phasen (R, S und T);
- Messen durch die Steuerungseinrichtung eines Spannungswertes zwischen jeder der Phasen und dem Schutzleiter;
- Durchführen der Messungen der vorhergehenden Schritte in einer ununterbrochenen zyklischen Weise;
- falls die Steuerungseinrichtung während der durchgeführten Messungen eine Spannung erfasst, die einen vorher festgelegten Schwellenwert übersteigt, Bestimmen eines Verlustes der Massereferenz; und
- Aktivieren eines Relais, um ein Signal einer elektrischen Störung als Ergebnis des Bestimmens des Verlustes der Massereferenz an ein externes Gerät zu senden.

## Revendications

1. Dispositif de commande et de protection (1) contre les pannes électriques dans un système d'alimentation électrique d'un réseau triphasé disposant d'un conducteur de protection, dans lequel le dispositif comprend :
- des premiers moyens d'acquisition (23) de chacune des phases du réseau triphasé ;
- des deuxièmes moyens d'acquisition (24) d'un signal provenant du conducteur de protection ;
**caractérisé en ce que** le dispositif comprend en outre :
- des moyens de commande (3, 4) configurés pour détecter une valeur de tension entre chacune des phases et le conducteur de protection et déterminer une perte de référence de masse si ladite valeur de tension dépasse un seuil préétabli ;
- au moins un élément de coupure électrique (9) commutable entre un état fermé pour la conduction et un état ouvert pour interrompre l'alimentation par les deuxièmes moyens d'acquisition (24), dans lequel la commutation d'un état fermé à un état ouvert se produit à la suite de la détermination de la perte de référence de masse ; et
- des moyens de transmission (8, 27 et 28) configurés pour transmettre un signal de panne électrique à un équipement externe, à la suite de la détermination de la perte de référence de masse.

2. Dispositif selon la revendication 1, comprenant en outre un boîtier de protection (22) à l'intérieur duquel sont logés tous les composants du dispositif.

3. Dispositif selon l'une des revendications précédentes, comprenant en outre une carte d'alimentation (20) avec une source d'alimentation CA/CC (2) agencée entre le réseau triphasé et les moyens de commande.

4. Dispositif selon l'une des revendications précédentes, comprenant en outre une carte mère (21) qui loge les moyens de commande et au moins un élément de coupure électrique commutable.

5. Dispositif selon les revendications 2 à 4, dans lequel les premiers et deuxièmes moyens d'acquisition sont une première (23) et une deuxième (24) bornes d'entrée agencées à l'extérieur du boîtier de protection et pouvant être connectées à la carte d'alimentation et à la carte mère, respectivement, à l'intérieur du boîtier de protection.

6. Dispositif selon les revendications précédentes, dans lequel les moyens de transmission comprennent une troisième (27) et une quatrième (28) bornes de sortie, agencées à l'extérieur du boîtier et pouvant être connectées à la carte d'alimentation et à la carte mère, respectivement, à l'intérieur du boîtier.

7. Dispositif selon la revendication 6, dans lequel les moyens de transmission comprennent une pluralité de relais (8) commutables entre un état ouvert et un état fermé, connectés aux troisième et quatrième bornes de sortie, dans lequel l'état dudit relais est sensible aux signaux envoyés par les moyens de commande en fonction de la détection de la perte de référence de masse.

8. Dispositif selon les revendications 3 et 4, comprenant en outre un premier bus (25) agencé entre la carte d'alimentation et la carte mère.

9. Dispositif selon la revendication 8, comprenant en outre un deuxième bus (26) agencé entre la carte d'alimentation et la carte mère.

10. Dispositif selon l'une des revendications précédentes, dans lequel les moyens de commande comprennent un microcontrôleur (3).

11. Dispositif selon l'une des revendications précédentes, comprenant en outre un bouton Redémarrer (5) configuré pour établir un état initial du dispositif.

12. Dispositif selon l'une des revendications précédentes, comprenant en outre des indicateurs visuels (6,7) d'un statut de fonctionnement du dispositif.

13. Dispositif selon l'une des revendications précédentes, dans lequel au moins un élément de coupure électrique commutable comprend deux relais de puissance connectés en série et agencés entres les deuxièmes moyens d'acquisition et les moyens de commande.

14. Procédé de commande et de protection contre les pannes électriques dans un système d'alimentation électrique d'un réseau triphasé avec un conducteur de protection CP, **caractérisé en ce qu'**il comprend les étapes suivantes :
- mesurer, par des moyens de commande, la tension de chacune des trois phases (R, S et T) ;
- mesurer, par les moyens de commande, une valeur de tension entre chacune des phases et le conducteur de protection ;
- effectuer les mesures des étapes précédentes de manière cyclique et ininterrompue ;
- dans le cas où les moyens de commande détectent une tension dépassant un seuil préétabli au cours des mesures effectuées, déterminer une perte de référence de masse ; et
- activer un relais afin d'émettre un signal de panne électrique à un équipement externe, à la suite de la détermination de la perte de référence de masse.
